Europäisches Patentamt

European Patent Office

Office européen des brevets

(19)

(11) Numéro de publication: **0 276 598 B1**

## (12) FASCICULE DE BREVET EUROPEEN

(45) Date de publication de fascicule du brevet:
**04.12.91**

(51) Int. Cl.⁵: **G11C 19/28**, G11C 27/04

(21) Numéro de dépôt: **87402857.4**

(22) Date de dépôt: **15.12.87**

(54) **Dispositif de multiplexage analogique par dispositifs à transfert de charge et son application à la lecture de signaux issus d'une structure matricielle de photodétecteurs.**

(30) Priorité: **19.12.86 FR 8617882**

(43) Date de publication de la demande:
**03.08.88 Bulletin 88/31**

(45) Mention de la délivrance du brevet:
**04.12.91 Bulletin 91/49**

(84) Etats contractants désignés:
**DE GB NL**

(56) Documents cités:
**US-A- 4 288 764**
**US-A- 4 306 160**

**3RD INTERNATIONAL CONFERENCE, THE TECHNOLOGY AND APPLICATIONS OF CHARGE COUPLED DEVICES, Edinburgh, septembre 1976, pages 315-325, GB; G.F. VANSTONE et al.: "A time delay and integration CCD for a serial scanned IR imager"**

(73) Titulaire: **THOMSON-CSF**
**51, Esplanade du Général de Gaulle**
**F-92800 Puteaux(FR)**

(72) Inventeur: **Coutures, Jean-Louis**
**THOMSON-CSF SCPI 19, avenue de Messine**
**F-75008 Paris(FR)**

(74) Mandataire: **Turlèque, Clotilde et al**
**THOMSON-CSF SCPI**
**F-92045 PARIS LA DEFENSE CEDEX 67(FR)**

Il est rappelé que: Dans un délai de neuf mois à compter de la date de publication de la mention de la délivrance du brevet européen, toute personne peut faire opposition au brevet européen délivré, auprès de l'Office européen des brevets. L'opposition doit être formée par écrit et motivée. Elle n'est réputée formée qu'après paiement de la taxe d'opposition (art. 99(1) Convention sur le brevet européen).

## Description

L'invention se rapporte au domaine du traitement de signaux issus de structures matricielles de détecteurs photosensibles, notamment de détecteurs infra-rouges, et plus particulièrement à un dispositif de multiplexage analogique, par dispositifs à transfert de charges, des signaux issus de tels détecteurs.

Pour le multiplexage d'échantillons de signaux analogiques, on connaît plusieurs solutions utilisant des registres à transfert de charges. Selon une première solution, les échantillons de signaux analogiques issus de plusieurs entrées, soit n, sont transférés en parallèle dans les différents étages d'un registre à transfert de charges de sortie, et lus en série sur la sortie analogique de ce registre de sortie. La fréquence de transfert du registre de sortie est n fois celle des échantillons d'entrée.

Une autre solution consiste à introduire à l'entrée d'un registre de sortie les échantillons issus des n registres d'entrée par commandes successives, réparties dans une période du signal d'entrée, de n portes analogiques reliant les sorties de ces registres d'entrée à l'entrée du registre de sortie.

Dans les deux modes de multiplexage succinctement définis ci-dessus, le transfert des échantillons analogiques entre les registres d'entrée et le registre de sortie est effectué par transfert de charges analogiques. Ces solutions imposent une juxtaposition entre les sorties des registres d'entrée et l'entrée, ou les entrées, du registre de sortie. En conséquence la dimension du registre de sortie, c'est-à-dire sa longueur lorsque les entrées se font en parallèle sur les étages d'un registre de sortie, ou sa largeur lorsque les entrées sont connectées à l'entrée du registre de sortie via des portes analogiques, est imposée par le pas de répétition des registres d'entrée. Or ces dimensions imposées peuvent être incompatibles de la géométrie nécessaire à un bon transfert dans le registre de sortie, ou peuvent être trop élevées compte-tenu de la charge à transférer augmentant ainsi inutilement le courant parasite d'obscurité dans le registre à transfert de charges de sortie.

D'autre part ces deux modes de multiplexage imposent des signaux de commande :

- un seul signal de commande pour le premier mode de transfert ce qui est assez peu contraignant ;
- autant de signaux de commande qu'il y a de portes dans la seconde solution, ce qui conduit à un système de conception plus compliquée et donc moins fiable. Un dispositif de multiplexage comportant plusieurs registres à transfert de charges parallèles qui sont décalés l'un vers l'autre et un registre à transfert de charges de sortie est connu de US-A-4 306 160. Ces registres à transfert de charge parallèles sont commandés par autant signaux de commande qu' il y a des registres parallèles.

La présente invention comme elle est exposée dans les revendications 1, 2 et 4 a pour objet un dispositif de multiplexage de n signaux analogiques échantillonnés, issus de n registres d'entrée à transfert de charges, et présents simultanément dans ces registres, vers un registre à transfert de charges de sortie qui permet de remédier aux inconvénients des dispositifs décrits ci-dessus par une structure qui élimine toute commande de portes de multiplexage, n'impose pas une juxtaposition particulière des n registres d'entrée et du registre de sortie comportant les charges multiplexées, et permet de réaliser un multiplexeur de signaux de fortes valeurs par rapport aux possibilités de stockage des registres à transfert de charges d'entrée.

Suivant un premier mode de réalisation de l'invention, un dispositif de multiplexage analogique par dispositifs à transfert de charge pour le multiplexage de n signaux analogiques échantillonnés à la fréquence $F_e$ issus en parallèle des étages de sortie de n registres à transfert de charge d'entrée, $E_1$ , $E_2$ , ... $E_n$, où ces signaux sont présents simultanément, vers un registre à transfert de charge de sortie S, est caractérisé en ce que n registres de multiplexage à transfert de charge, $R_1$ , $R_2$ , ... $R_n$, ayant respectivement 1, 2, ... n étages pour introduire respectivement des retards égaux à $1/nF_e$, $2/nF_e$, $3/nF_e$ ... $1/F_e$ reçoivent en parallèle les charges issues simultanément des registres d'entrée, le transfert étant effectué à la fréquence $nF_e$ dans ces registres, les sorties de ces registres de multiplexage étant reliées au premier étage du registre de sortie, S, ou ces charges sont décalées à la fréquence $nF_e$.

L'invention a également pour objet l'application de ce dispositif de multiplexage à la lecture de signaux issus d'une structure matricielle de photodétecteurs.

L'invention sera mieux comprise et d'autres caractéristiques apparaîtront à l'aide de la description qui suit en référence aux figures annexées.

- La figure 1 représente schématiquement un premier dispositif de multiplexage analogique connu ;
- La figure 2 représente schématiquement un second dispositif de multiplexage connu ;
- La figure 3 représenté un premier mode de réalisation du dispositif de multiplexage de signaux analogiques selon l'invention ;
- La figure 4 représente un second mode de réalisation du dispositif de multiplexage selon l'invention ;
- La figure 5 est un schéma détaillé partiel d'un dispositif de multiplexage selon l'invention applicable à une structure matricielle, dans lequel des groupes de signaux issus de cinq entrées successives sont transférés à une sortie commune ;

- Les figures 6a, 6b et 6c représentent respectivement en coupe les différentes électrodes de la structure selon la figure 5, et les diagrammes de potentiel correspondants, suivant l'état du signal de commande ;
- La figure 7 est le schéma d'un mode de réalisation dans lequel le registre de sortie réalise une sommation avec retard ;
- La figure 8 est un schéma illustrant une répartition des charges issues des registres d'entrée, pour le multiplexage.

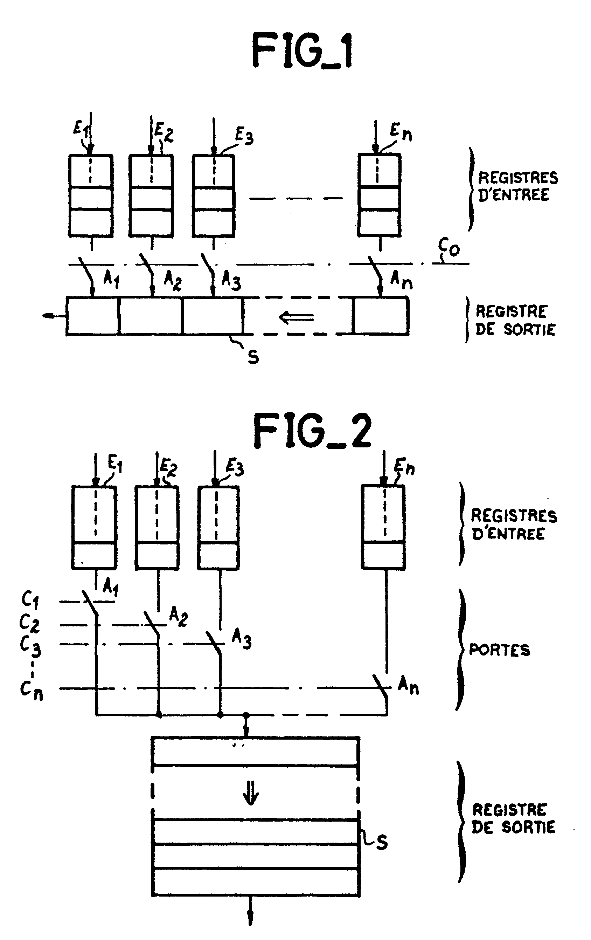

Sur la figure 1 qui représente un dispositif de multiplexage classique, n registres d'entrée $E_1$ , $E_2$ , ... $E_n$ sont reliés par l'intermédiaire de portes, respectivement $A_1$ , $A_2$ ... $A_n$, aux n entrées parallèles des n étages d'un registre à transfert de charges de sortie S. Dans ce mode de réalisation suivant l'art antérieur un seul signal de commande des portes $C_0$ permet de transférer simultanément les charges contenues dans les derniers étages des registres d'entrée $E_1$ ... $E_n$ respectivement aux n étages du registre de sortie. Si $F_e$ est la fréquence des échantillons dans les registres d'entrée $E_1$ ... $E_n$ , le registre de sortie à transfert de charges doit être lu à la fréquence $nF_e$, pour la sortie série des échantillons multiplexés, les échantillons présents à la sortie analogique du registre S étant au rythme $nF_e$. Comme indiqué ci-dessus, l'inconvénient de ce dispositif est qu'il impose au registre de sortie une longueur égale à n fois le pas de répétition, p, des registres d'entrée. De plus ce dispositif nécessite un signal de commande des portes.

La figure 2 représente un second dispositif de multiplexage selon l'art antérieur déjà décrit succinctement ci-dessus. Il comporte n registres d'entrée, $E_1$ , $E_2$ , ... , $E_n$, dont les étages de sortie sont tous couplés à l'entrée série d'un registre de sortie S, chacun par l'intermédiaire d'une porte, respectivement $A_1$ , $A_2$ , ... , $A_n$, chacune de ces portes recevant un signal de commande, respectivement $C_1$ , $C_2$ , ... , $C_n$ décalés : $F_e$ étant la fréquence des échantillons à l'entrée les signaux de commande sont décalés l'un par rapport au suivant de $1/nF_e$. Ainsi, le contenu des étages de sortie des registres d'entrée est transféré successivement au même étage d'entrée du registre de sortie S, le transfert des charges dans le registre de sortie étant effectué à la fréquence $nF_e$. Comme indiqué succinctement ci-dessus, ce dispositif de multiplexage a pour inconvénients d'une part le fait qu'il nécessite plusieurs signaux de commande décalés dans le temps, et que d'autre part la largeur géométrique du registre de sortie est multiple du pas de répétition du registre d'entrée, donc souvent trop grande par rapport à la quantité de charges à y transférer.

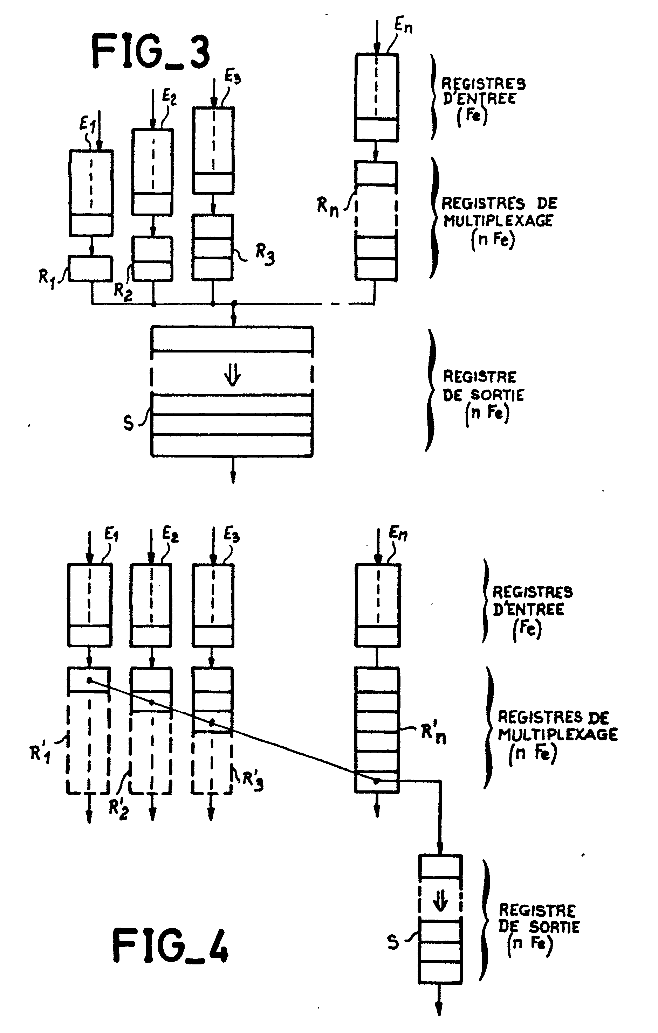

Dans le premier mode de réalisation du dispositif de multiplexage suivant l'invention représenté sur la figure 3, le transfert des charges des étages de sortie des registres d'entrée $E_1$ , $E_2$ , ... , $E_4$ ne s'effectue pas directement au registre de sortie S, mais par l'intermédiaire de registres intermédiaires de multiplexage, $R_1$ , $R_2$ , ... , $R_n$, chacun connecté à la sortie d'un registre d'entrée, les sorties des registres de multiplexage étant directement couplées à l'entrée série du registre de sortie S. Les charges présentes dans les derniers étages des registres d'entrée, $Q_1$ , $Q_2$ , ... $Q_n$ sont transférées simultanément dans les registres de multiplexage $R_1$ , $R_2$ ... $R_n$. Les registres intermédiaires introduisent des retards respectivement égaux à $1/nF_e$ , $2/nF_e$ , ... $1/F_e$. La charge $Q_1$ est disponible à la sortie du registre $R_1$ avec un retard $1/nF_e$, la charge $Q_2$ est disponible à la sortie du registre $R_2$ avec un retard $2/nF_e$, ... la charge $Q_n$ est disponible à la sortie du registre $R_n$ avec un retard $1/(Fe)$. Ainsi, le transfert dans le registre de sortie S avec des retards déterminés par les longueurs des registres $R_1$, $R_2$, ... $R_n$ réalise le multiplexage.

Cette solution élimine les signaux de commande de porte décrits ci-dessus. Néanmoins le décalage vertical des étages d'entrée des registres $E_1$ ... $E_n$, imposé par cette structure pour que les étages de sortie des registres de multiplexage soient adjacents, conduit à des problèmes lors de la conception ; en effet les répétitions de motifs destinés à former les électrodes ne se font pas suivant des axes orthogonaux du fait que les registres de multiplexage ne sont pas de longueurs identiques. De plus, du fait que le transfert doit être possible de tous les étages de sortie des registres de multiplexage à l'étage d'entrée du registre de sortie, la largeur de ce dernier registre est plus grande que ne le justifierait la quantité de charges à transférer à chaque pas d'horloge à fréquence $1/nF_e$.

La figure 4 représente un second mode de réalisation. préféré, de l'invention qui met en oeuvre des transferts analogues mais qui préserve la structure de répétition des motifs lors de la réalisation des réseaux d'électrodes et qui permet également d'adapter exactement les dimensions du registre de sortie au signal multiplexé de sortie. Pour cela, les échantillons analogiques transférés dans le registre de sortie S ne sont pas les charges formant les signaux d'entrée, ou charges "signal" elles-mêmes, transférées dans les registres intermédiaires de multiplexage, mais leurs images, ou charges équivalentes recréées, par lecture dite sur grille des charges "signal". Ces charges "signal" elles-mêmes peuvent alors être évacuées par les sorties de registres de multiplexage tous identiques.

La structure est alors la suivante : les registres d'entrée, parallèles, $E_1$ $E_2$ ... $E_n$, sont reliés aux étages d'entrée de registres intermédiaires de multiplexage $R'_1$ $R'_2$ ... $R'_n$ identiques, tous à n étages, les charges présentes dans les registres d'entrée étant évacuées par les sorties de ces différents registres. Pour le multiplexage, une connexion de lecture reliant une grille de lecture du premier étage du registre $R'_1$ , une grille de lecture du second étage du registre $R'_2$ , etc ...., une grille de lecture du $n^{ième}$ étage du registre $R'_n$, est reliée à l'entrée du registre de sortie S. Cette connexion de lecture permet, lorsque les charges "source" passent sous l'étage connecté au bus de lecture à des instants espacés de $1/nF_e$, de créer dans l'étage d'entrée du registre de sortie les charges images, ou charges équivalentes recréées. Ces charges $Q'_1$ , $Q'_2$ ... $Q'_n$, images des charges sources présentes dans les registres de multiplexage $R'_1$ , $R'_2$ ... $R'_n$ et résultant de la lecture, sont transférées dans le registre de sortie avec une composante continue $Q_0$ positive, négative ou nulle selon le réglage d'une polarisation externe. Sur la figure 4, les étages utiles au multiplexage pour les différents registres de multiplexage $R'_1$ , $R'_2$ ... $R'_n$ ont été marqués en traits pleins, ceux non utilisés pour le multiplexage et qui servent seulement à la continuité des grilles de transfert dans le cadre d'une répétition du système de multiplexage, étant représentés en traits pointillés. Les charges issues des différents registres intermédiaires de multiplexage peuvent être évacuées par un drain commun.

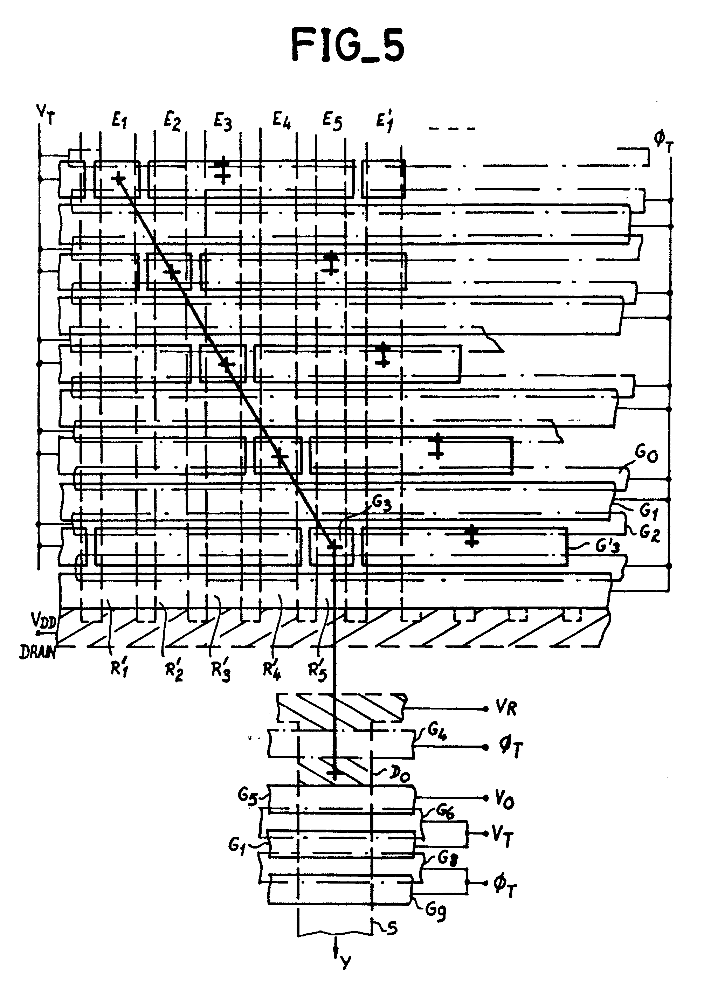

La figure 5 est un schéma détaillé partiel d'un ensemble de multiplexage selon l'invention comportant une série d'entrées groupées par cinq, les signaux transmis par les cinq registres d'entrée $E_1$ , $E_2$ ... $E_5$, non représentés, étant multiplexés sur un registre à transfert de charges de sortie S au moyen de registres intermédiaires de multiplexage réalisés de la manière suivante : les registres de multiplexage $R'_1$ , $R'_2$ ... $R'_5$ sont délimités par les pointillés verticaux sur la figure 5, qui marquent l'isolement entre registres. De même le registre à transfert de charges de sortie S est délimité de la même manière par un isolement marqué par des traits pointillés. Sur le substrat, sur un premier niveau, deux réseaux d'électrodes parallèles, intercalés sont réalisés, $G_1$ et $G'_3$ , représentés en trait plein, ces réseaux étant orthogonaux au sens de transfert dans les registres à transfert de charges. Un masquage est réalisé pour isoler des grilles de lecture $G_3$ dans le réseau $G'_3$, au niveau des étages 1, 2, ... n, des registres intermédiaires. En même temps que ces deux réseaux destinés à la formation des registres à transfert de charges intermédiaires, les grilles du premier niveau du registre de sortie S sont également réalisées, $G_5$ , $G_7$ , $G_9$ sur la figure 5 où seul le premier étage du registre de transfert de sortie est représenté.

Sur un second niveau du circuit sont réalisées une seconde série d'électrodes, décalées par rapport aux électrodes du premier niveau, et formant également deux réseaux, $G_0$ et $G_2$, parallèles intercalés. En même temps que ces deux réseaux parallèles, une électrode $G_4$ et des réseaux intercalés d'électrodes $G_6$ et $G_8$ du registre de sortie S sont formés au second niveau des circuits, ces réseaux étant décalés et recouvrant partiellement les électrodes $G_5$ et $G_7$ d'une part et $G_7$ et $G_9$ d'autre part. Deux zones de diffusion sont également réalisées pour la formation des charges images, de part et d'autre de la grille $G_4$, l'une $D_0$ entre les deux électrodes $G_4$ et $G_5$, et l'autre de l'autre côté de la grille $G_4$, portée à un potentiel $V_R$. Les réseaux d'électrodes $G_0$ et $G_1$ sont polarisés par un signal de commande, $\emptyset_T$ à deux niveaux, de niveau haut $V_1$ et de niveau bas $V_2$ , tandis que le réseau d'électrodes $G'_3$ est relié à une tension de transfert $V_T$, par connexion avec le réseau sous-jacent $G_2$ , également porté à ce potentiel.

Dans le registre de sortie, la grille $G_5$ est polarisée par une tension continue $V_0$ , $G_6$ et $G_7$ sont polarisées par la tension $V_T$, et $G_8$ et $G_9$ reçoivent le signal de commande $\emptyset_T$. Sur les grilles de lecture $G_3$, des contacts sont prévus, ainsi qu'une connexion oblique en aluminium qui relie ces différents éléments de grille $G_3$. L'élément de grille $G_3$ du cinquième étage du registre à décalage $R_5$ est relié au moyen d'un contact Al-Grille, d'une connexion, et d'un contact Al-Diode à la zone de diffusion $D_0$. Enfin, les registres à décalage $R'_1$ , $R'_2$ ... $R'_5$ aboutissent tous à un drain commun, au potentiel $V_{DD}$ qui permet l'évacuation des charges transférées dans ces registres.

La lecture des registres intermédiaires est une méthode de lecture en courant décrite dans les demandes de brevet FR-A-2 430 694 et FR-A-2 513 832 au nom de la Demanderesse, méthode dans laquelle une variante est utilisée : le courant n'est pas converti en tension par une capacité mais conservé sous forme de charges dans un puits de potentiel d'un étage à transfert de charges du registre de sortie.

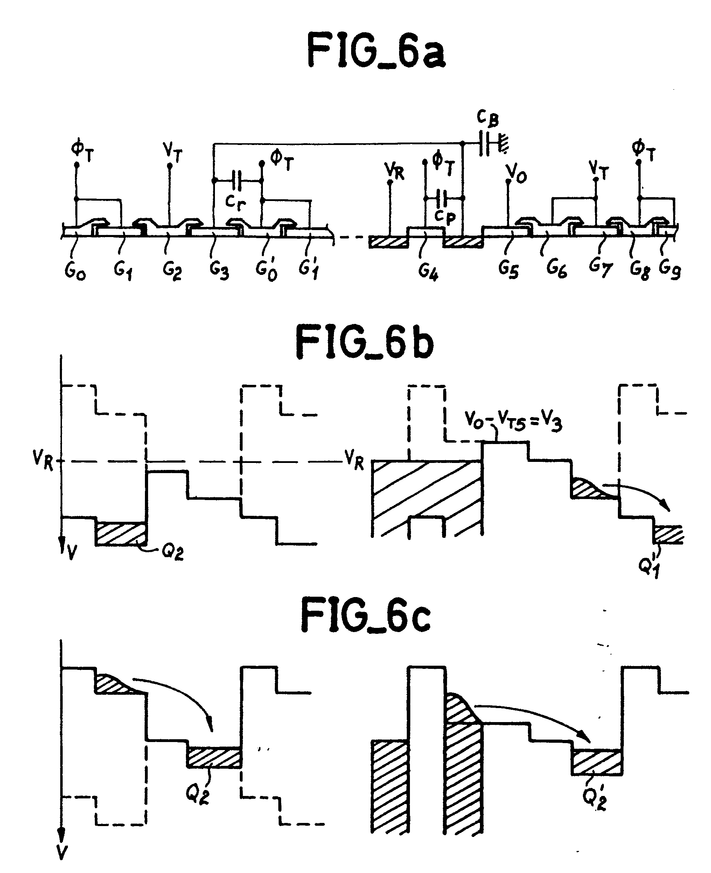

Les figures 6a, 6b et 6c illustrent respectivement en coupe suivant Y la structure de la figure 5, et les diagrammes de potentiel de canal associés, lorsque le signal de commande $\emptyset_T$ est respectivement au niveau haut $V_1$ (figure 6b) et au niveau bas $V_2$ (figure 6c). Les mêmes références que sur la figure 5 ont été utilisées pour désigner les différentes grilles de la structure, $G_0$ et $G'_0$ étant deux électrodes du réseau $G_0$, $G_1$ et $G'_1$ étant deux électrodes du réseau $G_1$. Ces figures permettent

d'illustrer le procédé de lecture utilisé dans ce mode de réalisation du dispositif de multiplexage. Sur la partie gauche de la figure sont représentées les différentes grilles, et les potentiels de canal associés, formant l'étage lu d'un registre intermédiaire, et sur la partie droite de ces figures les différentes grilles formant la zone de formation des charges images et le premier étage du registre de sortie, et les potentiels de canal associés.

Les registres à transfert de charges ont un transfert à commande en monophase c'est-à-dire que le signal de commande de transfert $\emptyset_T$ prend successivement comme indiqué ci-dessus un état haut $V_1$ et un état bas $V_2$. Ce signal est appliqué au couple de grilles $G_0$, $G_1$ des registres de multiplexage ; une tension continue $V_T$ égale à $(V_1-V_2)/2$ est appliquée à la grille $G_2$. Comme indiqué ci-dessus l'étage à lire est constitué des grilles successives dans le sens de transfert $G_0$, $G_1$, $G_2$ et $G_3$. Une implantation pour dissymétriser les potentiels est appliquée dans le substrat silicium, sous les grilles $G_0$ et $G_2$.

Dans la séquence de lecture, deux états stables existent : la figure 6b représente le premier état stable, quand le signal de commande $\emptyset_T$ est à l'état haut :

Dans ce cas, côté registre intermédiaire la charge Q est stockée sous la grille $G_1$ ; soit $Q = Q_2$ si c'est le deuxième étage du registre intermédiaire $R'_2$ qui est lu.

Le potentiel de la grille $G_3$ est le potentiel $V_R$, cette grille $G_3$ étant portée à ce potentiel par l'intermédiaire de la connexion de lecture qui relie la grille $G_3$ à la diffusion $D_0$, alors au potentiel $V_R$, puisque $\emptyset_T$ est à l'état haut $V_1$.

Pour l'autre partie de la figure, dans la zone de diffusion et le premier étage du registre de sortie, la tension continue $V_0$ appliquée à $G_5$ fait que le potentiel de canal sous $G_5$ est égal à $V_0-V_{T5}$. On choisit $V_0$ pour que que $V_0-V_{T5}$ soit égale à $(V_1-V_2)/2$, $V_{T5}$ étant le seuil de conduction sous la grille $G_5$. Les charges images correspondant aux charges sources lues dans le registre intermédiaire précédent, soit $Q'_1$, et stockées sous $G_7$ dans la phase précédente où $\emptyset_T$ était à l'état bas, sont alors transférées sous $G_9$ alors au potentiel $\emptyset_T$ haut : $V_1$.

Lorsque le signal de commande de transfert $\emptyset_T$ passe à l'état bas, la figure 6c montre dans sa partie gauche que la charge $Q_2$ initialement sous $G_1$ est transférée sous la grille $G_3$ du fait que le potentiel appliqué à $G_1$ diminue à $V_2$ tandis que le potentiel sous $G_3$ diminue. Le potentiel de la connexion de lecture devient flottant par coupure de la conduction du canal sous $G_4$, et donc de $G_3$, s'établit au potentiel de canal sous la grille $G_5$ du registre de sortie S c'est-à-dire au potentiel $(V_1-V_2)/2$.

Une charge image $Q'_2$ peut alors être transférée de la diode $D_0$ vers le puits de potentiel sous $G_7$ du registre de sortie puis sous $G_9$ lors du passage suivant de $\emptyset_T$ à l'état haut (comme indiqué ci-dessus). cette charge image $Q'_2$ est telle que :

$$Q'_2 = Q_2 + (C_p+C_r)\emptyset - |V_R-(V_0-V_{T5})| \times C_B$$

où $\emptyset = V_1-V_2$, $C_p$ et $C_r$ étant les capacités de couplage entre successivement $G_4$ et le bus de lecture, et $G'_0$ et le bus de lecture et $C_B$ étant la capacité du bus de lecture. Soit $Q'_2 = Q_2 + Q_0$.

On voit que, suivant la tension $V_R$, la charge $Q_0$ peut être positive, négative ou nulle et donc que la composante continue appliquée peut être réglée :

- $Q_0 = 0$ avec $V_R$ égale à $(C_p + C_r)\emptyset/C_B + -(V_0-V_{T5}) = V$
- $Q_0$ positif avec $V_R$ inférieur à $V$ ; dans ce cas un fond de charge supplémentaire $Q_0$ est ajouté à la charge $Q_2$ pour former la charge image $Q'_2$ ;
- $Q_0$ négatif avec $V_R$ supérieur à $V$ ; dans ce cas le signal initial de charge $Q_2$ est ébasé pour former le signal généré dans le registre de sortie.

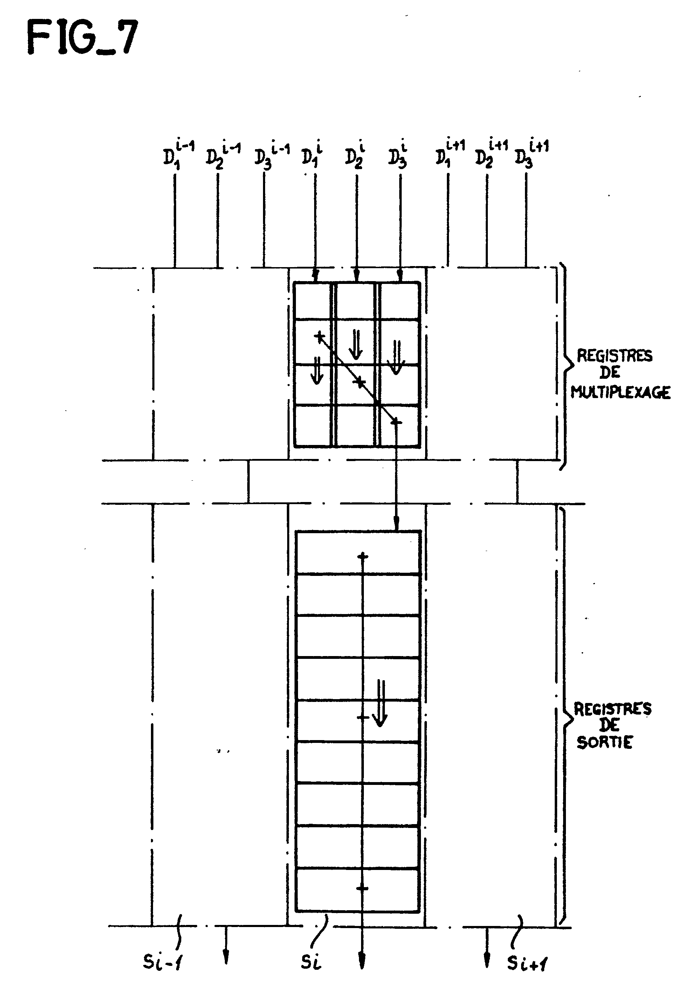

Le dispositif de multiplexage selon l'invention est particulièrement applicable à la lecture, dans "le plan focal" c'est-à-dire dans le plan où l'image est formée, de signaux issus d'une structure matricielle de détecteurs photosensibles, comme le montre la figure 7.

Les signaux issus de n photodiodes $D_1^i$, $D_2^i$, $D_3^i$ avec n = 3 d'une même colonne i de la matrice sont multiplexés vers un registre de sortie $S_i$ qui réalise une sommation avec retard des signaux issus de ces n photodiodes, selon la méthode de traitement dite TDI (en anglais Time Delay Integration) décrite notamment dans la demande de brevet FR-A-2 577 340 au nom de la Demanderesse. Ce traitement doit être réalisé simultanément pour toutes les colonnes ... i-1, i, i+1 ... de la matrice, ce qui impose une structure parallèle de traitement TDI dans les registres de sortie ... $S_{i-1}$, $S_i$, $S_{i+1}$, au pas imposé par les photodiodes, tel que défini sur la figure 7 dans un exemple de multiplexage de trois voies vers une voie.

La charge qui peut être stockée dans les registres multiplexeurs est fonction de la géométrie de l'étage à transfert de charges et plus particulièrement de la largeur des registres à transfert de charges (la longueur est essentiellement limitée par la fréquence de transfert). Dans une application où le pas de répétition pour le traitement TDI, prend en compte un nombre relativement élevé de photodiodes par colonne, les registres de multiplexage sont de faible largeur.

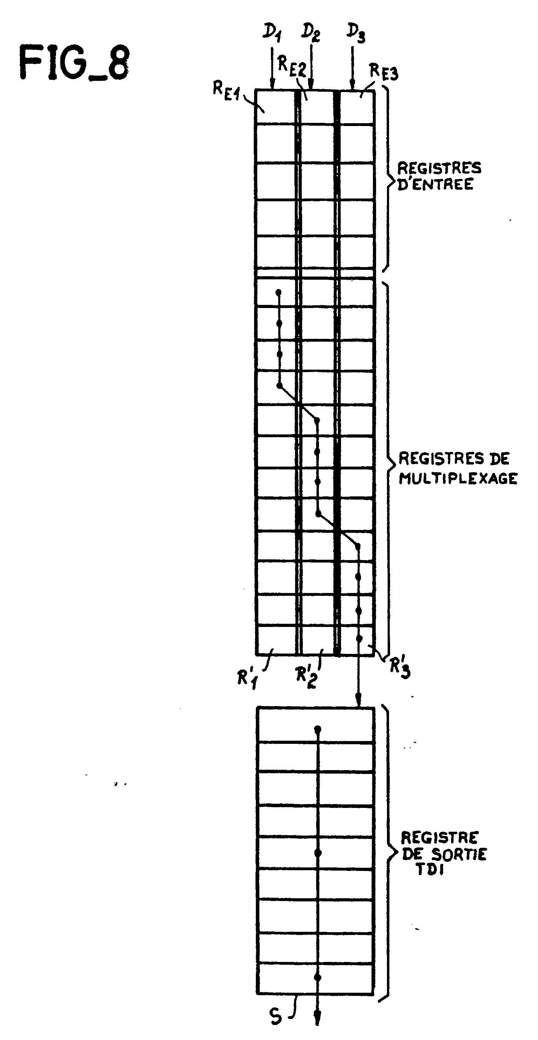

Pour un signal en charge issu des photodiodes important, une solution pour réaliser le transfert correct de ces charges consiste à répartir chaque signal élémentaire en m "paquets" de charges répartis sur m étages de registres à transfert de charges d'entrée, puis de transférer ceux-ci vers les registres de multiplexage à la fréquence $nmF_e$. La figure 8 montre un schéma de répartition des charges constituant un signal respectivement $D_1$, $D_2$ et $D_3$ dans m = 4 étages de registres à transfert de charges d'entrée $R_{E1}$, $R_{E2}$, $R_{E3}$, puis de multiplexage de 3 voies vers 1, via trois registres de multiplexage, $R'_1$, $R'_2$ et $R'_3$ ayant chacun n.m = 12 étages. Pour cela la connexion de lecture relie les 4 premiers étages du registre $R'_1$, les 4 étages du milieu du registre $R'_2$ et les 4 derniers étages du registre $R'_3$ au premier étage du registre de sortie à intégration S. La reconstitution du signal initial est alors réalisée par une lecture simultanée des m paquets de charges issus de la même photodiode, ces charges étant présentes simultanément sur m étages dont les grilles sont connectées par la connexion de lecture. Le transfert des registres diviseurs d'entrée et des registres de multiplexage est réalisé à la fréquence $m\,n.F_e$, si $F_e$ est la fréquence de lecture des photodiodes.

**Revendications**

1.  Dispositif de multiplexage analogique par dispositifs à transfert de charge pour le multiplexage de n signaux analogiques échantillonnés à la fréquence $F_e$ issus en parallèle des étages de sortie de n registres à transfert de charge d'entrée, $E_1$, $E_2$, ... $E_n$, où ces signaux sont présents simultanément, vers un registre à transfert de charge de sortie S, caractérisé en ce que n registres de multiplexage à transfert de charge, $R_1$, $R_2$, ... $R_n$, ayant respectivement 1, 2, ... n étages pour introduire respectivement des retards égaux à $1/nF_e$, $2/nF_e$, $3/nF_e$ ... $1/F_e$ reçoivent en parallèle les charges issues simultanément des registres d'entrée, le transfert étant effectué à la fréquence $nF_e$ dans ces registres, les sorties de ces registres de multiplexage étant reliées au premier étage du registre de sortie, S, ou ces charges sont décalées à la fréquence $nF_e$.

2.  Dispositif de multiplexage analogique par dispositifs à transfert de charge pour le multiplexage de n signaux analogiques échantillonnés à la fréquence $F_e$ issus en parallèle des étages de sortie de n registres à transfert de charge d'entrée, $E_1$, $E_2$ ... $E_n$, où ces signaux sont présents simultanément, caractérisé en ce que n registres de multiplexage à transfert de charges $R'_1$, $R'_2$, ... $R'_n$, reçoivent en parallèle sur leurs étages d'entrée les charges issues simultanément des registres d'entrée et les transfèrent aux étages successifs à la fréquence $nF_e$, et en ce qu'une électrode de lecture relie respectivement les étages de rangs i, i = 1 à n, des n registres de multiplexage $R'_i$ au premier étage du registre de sortie, des charges images ($Q'_i$) des charges ($Q_i$) contenues dans ces étages respectifs à des instants décalés de $1/nF_e$ étant créées dans le registre de sortie où elles sont décalées à la fréquence $nF_e$.

3.  Dispositif selon la revendication 2, caractérisé en ce que les n registres de multiplexage ont tous n étages et ont donc la même longueur, les charges "signal" étant transférées successivement dans les n étages de ces registres avant leur évacuation via un drain commun reliant tous leurs étages de sortie.

4.  Dispositif de multiplexage analogique par dispositifs à transfert de charge pour le multiplexage de n signaux analogiques simultanés de fortes valeurs, échantillonnés à la fréquence $F_e$, chaque échantillon étant reparti en m paquets de charges dans m étages successifs de registres parallèles d'entrée respectifs, $R_{E1}$, $R_{E2}$, ... $R_{En}$, où ces signaux sont présents simultanément,
    caractérisé en ce que n registres de multiplexage à transfert de charges $R'_i$, i = 1 à n, à n.m étages reçoivent en parallèle sur leurs étages d'entrée les charges issues des registres d'entrée à la fréquence $n.m.F_e$ et les transfèrent aux étages successifs à la même fréquence, et en ce qu'une connexion relie les étages de rangs $|(i-1)m + 1|$ à $(i.m)$ des registres de multiplexage successifs $R'_i$, pour i = 1 à n, au premier étage d'un registre de sortie à transfert de charge S, des charges images ($Q'_i$) des charges ($Q_i$) contenues dans ces étages interconnectés, à des instants décalés de $1/n.F_e$, étant créées dans l'étage d'entrée du registre de sortie, où elles sont alors décalées à la fréquence $n.F_e$.

5.  Dispositif selon l'une des revendications 3 et 4, caractérisé en ce que le registre de sortie (S) est un registre de sommation avec retard qui effectue le cumul de charges transférées successivement dans une suite d'étages successifs.

6.  Application du dispositif selon l'une des revendications précédentes à la lecture de signaux issus d'une structure matricielle de photodétecteurs, caractérisée en ce que les signaux analogiques multiplexés sont les signaux issus d'une suite de n photodiodes appartenant à une même colonne de la matrice.

7. Application selon la revendication 6, caractérisée en ce que les registres d'entrée réalisent une répartition du signal issu de chaque photodiode dans une suite de m étages du registre d'entrée correspondant.

## Claims

1. An analog multiplexing device using charge transfer devices for the multiplexing of n analog signals sampled at the frequency $F_e$ coming in parallel from the output stages of n input charge transfer registers, $E_1$, $E_2$,...$E_n$, wherein the said signals are simultaneously present, into an output charge transfer register S, characterized in that n multiplexing charge transfer registers $R_1$, $R_2$,...$R_n$ respectively having 1, 2,...n stages in order to respectively introduce delays equal to $1/nF_e$, $2/nF_e$, $3/nF_e$...$1/F_e$ receive in parallel the charges which simultaneously come from the input register, the transfer being performed at the frequency $nF_e$ in the said registers, the outputs of these multiplexing registers being connected with the first stage of the output register S where the said charges are shifted to the frequency $nF_e$.

2. An analog multiplexing device using charge transfer devices for the multiplexing of n analog signals sampled at the frequency Fe coming in parallel from the output stages of n input charge transfer registers, $E_1$, $E_2$,...$E_n$, wherein the said signals are simultaneously present, characterized in that n input multiplexing charge transfer registers $R'_1$, $R'_2$,...$R'_n$ receive in parallel at their input stages the charges coming simultaneously from the input registers and transfer them to the succeeding stages at the frequency $nF_e$, and in that a read electrode respectively connects the stages of the ranks i for i = 1 to n, of the n multiplexing registers $R'_i$ with the first stage of the output register, image charges ($Q'_i$) of charges ($Q_i$) contained in the said respective stages at instants shifted by $1/nF_e$ being created in the output register where they are shifted to the frequency $nF_e$.

3. A device as claimed in claim 2, characterized in that the n multiplexing registers all have n stages and therefore have the same length, the "signal" charges being transferred successively into the n stages of the said registers prior to being removed via a common drain connecting all their output stages.

4. An analog multiplexing device using charge transfer devices for the multiplexing of n simultaneous analog signals with high values sampled at the frequency $F_e$, each sample being placed in m charge packages in m successive stages of respective parallel input registers $R_{E1}$, $R_{E2}$,...$R_{En}$, where the said signals are simultaneously present, characterized in that n multiplexing charge transfer registers $R'_i$, i = 1 to n with n•m stages receive in parallel at their input stages the charges coming from the input registers at the frequency $n•m•F_e$ and transfer them to the succeeding stages at the same frequency, and in that one connection connects the stages of the ranks $|(i - 1)m + 1|$ to $(i•m)$ of the succeeding multiplexing registers $R'_1$ for i = 1 to n, to the first stage of an output charge transfer register S, image charges ($Q'_i$) of charges ($Q_i$) contained in the said interconnected stages, at instants shifted by $1/n•F_e$, being created in the input stage of the output register, where they are shifted to the frequency $n•F_e$.

5. The device as claimed in claim 3 or in claim 4, characterized in that the output register (S) is a summating register with a delay which performs the cumulation of the charges which are transferred successively to a series of successive stages.

6. The application of the device as claimed in any one of the preceding claims for the reading of signals coming from a photodetector matrix structure, characterized in that the analog multiplexed signal are the signals coming from a series of n photodiodes belonging to one column of the matrix.

7. The application of the device as claimed in claim 6, characterized in that the input registers perform a distribution of the signals coming from each photodiode in a series of m stages of the corresponding input register.

## Patentansprüche

1. Vorrichtung zur analogen Multiplexierung mittels Ladungstransportvorrichtungen für die Multiplexierung von n mit der Frequenz $F_e$ abgetasteten Analogsignalen, die von Ausgangsstufen von n Eingangs-Ladungstransportregistern $E_1$, $E_2$,..., $E_n$, an denen diese Signale gleichzeitig vorliegen, an ein Ausgangs-Ladungstransportregister S parallel ausgegeben werden, dadurch gekennzeichnet, daß n Ladungstransport- Multiplexierungsregister $R_1$, $R_2$,..., $R_n$, die jeweils 1, 2,..., n Stufen zum Einführen von Verzögerungen, die entsprechend gleich $1/nF_e$, $2/nF_e$, $3/nF_e$,..., $1/F_e$ sind, besitzen, die von den Eingangsregistern gleichzeitig ausgegebenen Ladungen empfangen, wobei der Transport in diesen Registern mit der Frequenz nFe ausgeführt wird, wobei die Ausgänge dieser Multiplexierungsregister mit der ersten Stufe des Ausgangsregisters S, in der die Ladungen mit der Frequenz nFe verschoben werden, verbunden sind.

2. Vorrichtung zur analogen Multiplexierung mittels Ladungstransportvorrichtungen für die Multiplexierung von n mit der Frequenz $F_e$ abgetasteten Analogsignalen, die von Ausgangsstufen von n Eingangs-Ladungstransportregistern $E_1$, $E_2$,..., $E_n$, an denen diese Signale gleichzeitig vorliegen, parallel ausgegeben werden, dadurch gekennzeichnet, daß n Ladungstransport-Multiplexierungsregister $R'_1$, $R'_2$,..., $R'_n$ an ihren Eingangsstufen die von den Eingangsregistern gleichzeitig ausgegebenen Ladungen parallel empfangen und sie an die nachfolgenden Stufen mit der Frequenz $nF_e$ übertragen und daß eine Leseelektrode jeweils die Stufen vom Rang i, i = 1 bis n, der n Multiplexierungsregister $R'_i$ mit der ersten Stufe des Ausgangsregisters verbindet, wobei Bildladungen ($Q'_i$) von Ladungen ($Q_i$), die in diesen entsprechenden Stufen in Momenten, die um $1/nF_e$ zeitversetzt sind, enthalten sind, im Ausgangsregister, in dem sie mit der Frequenz nFe verschoben werden, erzeugt werden.

3. Vorrichtung gemäß Anspruch 2, dadurch gekennzeichnet, daß alle n Multiplexierungsregister n Stufen und folglich die gleiche Länge besitzen, wobei die "Signal"-Ladungen nacheinander in den n Stufen dieser Register transportiert werden, bevor sie über einen gemeinsamen Drain, der sämtliche ihrer Ausgangsstufen verbindet, ausgegeben werden.

4. Vorrichtung zur analogen Multiplexierung mittels Ladungstransportvorrichtungen für die Multiplexierung von n mit der Frequenz $F_e$ abgetasteten gleichzeitigen Analogsignalen mit hohen Werten, wobei jedes abgetastete Signal in den n aufeinanderfolgenden Stufen der jeweiligen parallelen Eingangsregister $R_{E1}$, $R_{E2}$,..., $R_{En}$, in denen diese Signale gleichzeitig vorliegen, auf m Ladungspakete verteilt werden, dadurch gekennzeichnet, daß n Ladungstransport-Multiplexierungsregister $R'_i$, i = 1 bis n, mit $n \cdot m$ Stufen an ihren Eingangsstufen die von den Eingangsregistern ausgegebenen Ladungen mit der Frequenz $n \cdot m \cdot Fe$ empfangen und sie an die nachfolgenden Stufen mit der gleichen Frequenz übertragen und daß eine Verbindung die Stufen vom Rang $|(i=1)m + 1|$ bis $(i \cdot m)$ der aufeinanderfolgenden Multiplexierungsregister $R'_i$, für i = 1 bis n, mit der ersten Stufe eines Ladungstransport-Ausgangsregisters S verbindet, wobei Bildladungen ($Q'_i$) der Ladungen ($Q_i$), die in Momenten, die um $1/n \cdot F_e$ zeitversetzt sind, in diesen miteinander verbundenen Stufen enthalten sind, in der Eingangsstufe des Ausgangsregisters, wo sie folglich mit der Frequenz $n \cdot F_e$ verschoben werden, erzeugt werden.

5. Vorrichtung gemäß einem der Ansprüche 3 und 4, dadurch gekennzeichnet, daß das Ausgangsregister (S) ein Summierungsregister mit Verzögerung ist, das die Summierung der in einer Folge von aufeinanderfolgenden Stufen aufeinanderfolgend transportierten Ladungen ausführt.

6. Anwendung der Vorrichtung gemäß einem der vorangehenden Ansprüche auf das Lesen von Signalen, die von einer Matrixanordnung von Photodetektoren ausgegeben werden, dadurch gekennzeichnet, daß die einer Multiplexierung unterworfenen Analogsignale die Signale sind, die von einer Folge von n Photodioden ausgegeben werden, die zur gleichen Spalte der Matrix gehören.

7. Anwendung gemäß Anspruch 6, dadurch gekennzeichnet, daß die Eingangsregister eine Verteilung des von jeder Photodiode ausgegebenen Signals in eine Folge von m Stufen des entsprechenden Eingangsregisters bewerkstelligen.

# FIG_1

$E_1$   $E_2$   $E_3$   $E_n$

REGISTRES
D'ENTREE

$C_0$

$A_1$   $A_2$   $A_3$   $A_n$

REGISTRE
DE SORTIE

S

# FIG_2

$E_1$   $E_2$   $E_3$   $E_n$

REGISTRES
D'ENTREE

$C_1$   $A_1$
$C_2$   $A_2$
$C_3$   $A_3$

PORTES

$C_n$   $A_n$

REGISTRE
DE SORTIE

S

# FIG_3

REGISTRES
D'ENTREE
(Fe)

REGISTRES DE
MULTIPLEXAGE
(n Fe)

REGISTRE
DE SORTIE
(n Fe)

REGISTRES
D'ENTREE
(Fe)

REGISTRES DE
MULTIPLEXAGE
(n Fe)

REGISTRE
DE SORTIE
(n Fe)

# FIG_4

# FIG_5

# FIG_6a

# FIG_6b

# FIG_6c

# FIG_7

$D_1^{i-1}$  $D_2^{i-1}$  $D_3^{i-1}$  $D_1^i$  $D_2^i$  $D_3^i$  $D_1^{i+1}$  $D_2^{i+1}$  $D_3^{i+1}$

REGISTRES
DE
MULTIPLEXAGE

REGISTRES
DE
SORTIE

$S_{i-1}$  $S_i$  $S_{i+1}$

# FIG_8

REGISTRES
D'ENTREE

REGISTRES DE
MULTIPLEXAGE

REGISTRE
DE SORTIE
TDI